# EUROPEAN PATENT SPECIFICATION

(11) **EP 3 303 649 B1**
(45) Date of publication and mention of the grant of the patent: **13.09.2023**
(21) Application number: 16728572.5
(22) Date of filing: 03.06.2016
(51) Int. Cl.: C22F 1/047, C22C 21/06, B22D 15/00, B22D 21/00, C22C 21/08

(54) **AN AUTOMOTIVE BODY PART COMPRISING AN ALUMINIUM ALLOY AND A METHOD FOR PRODUCING THE AUTOMOTIVE BODY PART**
KRAFTFAHRZEUGKAROSSERIETEIL BEINHALTEND EINE ALUMINIUMLEGIERUNG UND VERFAHREN ZUR HERSTELLUNG DES KRAFTFAHRZEUGKAROSSERIETEILS
UNE PIÈCE DE CARROSSERIE D'AUTOMOBILE COMPRENANT UN ALLIAGE D'ALUMINIUM ET UN PROCÉDÉ DE PRODUCTION DE LA PIÈCE DE CARROSSERIE D'AUTOMOBILE

(30) Priority: 05.06.2015 US 201562171344 P
(43) Date of publication of application: 11.04.2018
(73) Proprietor: Novelis, Inc., Atlanta, GA 30326 (US)
(72) Inventor: KADALI, Jyothi, Woodstock, Georgia 30188 (US); GATENBY, Kevin Michael, Johns Creek, Georgia 30022 (US); KANG, DaeHoon, Kennesaw, Georgia 30144 (US); DAS, Sazol Kumar, Acworth, Georgia 30102 (US)
(74) Representative: Weickmann & Weickmann PartmbB
(86) International application number: PCT/US2016/035701
(87) International publication number: WO 2016/196921

(56) References cited:
- EP-A1- 0 681 034
- EP-A1- 0 818 553
- EP-A1- 1 748 088
- WO-A1-03/074747
- CA-A1- 2 882 691
- CN-A- 103 243 247
- CN-A- 104 561 696
- JP-A- 2005 139 494
- JP-A- 2010 053 367
- "International Alloy Designations and Chemical Composition Limits for Wrought Aluminum and Wrought Aluminum Alloys With Support for On-line Access From: Aluminum Extruders Council Aluminium Federation of South Africa Australian Aluminium Council Ltd. European Aluminium Association Japan Aluminium Ass", , 1 February 2009 (2009-02-01), XP055136121, Retrieved from the Internet: URL:http://www.aluminum.org/sites/default/ files/Teal_Sheets.pdf [retrieved on 2014-08-22]
- SUBODH K. DAS: "Designing Aluminium Alloys for a Recycling Friendly World", MATERIALS SCIENCE FORUM, vol. 519-521, 1 January 2006 (2006-01-01), pages 1239-1244, XP055293707, DOI: 10.4028/www.scientific.net/MSF.519-521.123 9
- GABRIELLE GAUSTAD ET AL: "Design for Recycling", JOURNAL OF INDUSTRIAL ECOLOGY, vol. 14, no. 2, 1 March 2010 (2010-03-01), pages 286-308, XP055293708, ISSN: 1088-1980, DOI: 10.1111/j.1530-9290.2010.00229.x

## Description

### FIELD

Provided herein are novel aluminum alloy compositions for use in automotive applications and methods of making and processing the same. In some cases, the alloys described herein exhibit high formability, high strength, and corrosion resistance. The alloys described herein are also highly recyclable.

### BACKGROUND

Recyclable aluminum alloys that can be used in multiple applications, including transportation applications, are desirable. Such alloys should exhibit high strength, high formability, and corrosion resistance. However, producing such alloys has proven to be a challenge, as hot rolling of compositions with the potential of exhibiting the desired properties often results in edge cracking issues and the propensity for hot tearing.

CA 2 882 691 A1 is directed to an aluminum alloy strip composed of an AA5xxx-type aluminum alloy, which apart from Al and inevitable impurities has an Mg content of at least 4 wt.% characterized in that the aluminum alloy strip has a recrystallized microstructure, wherein the grain size (GS) of the microstructure satisfies the following dependency on the Mg content (c_Mg) in wt.%: GS > 22 + 2^{∗}c_Mg and in that the aluminum alloy of the aluminum alloy strip has the following composition in wt.%: Si ≤ 0.2%, Fe ≤ 0.35%, 0.04% ≤ Cu ≤ 0.08%, 0.2% ≤ Mn ≤ 0.5%, 4.35% ≤ Mg ≤ 4.8%, Cr ≤ 0.1%, Zn ≤ 0.25%, Ti ≤ 0.1%, the remainder being Al and inevitable impurities, amounting to a maximum of 0.05 wt.% individually and a maximum of 0.15 wt.% in total.

CN 103243247 A relates to an aluminum alloy, which comprises the following components: 4.0-6.0 wt.% of Mg, 0.20-0.50 wt.% of Cu, 0.05-0.30 wt.% of Mn, 0.05-0.30 wt.% of Fe, 0.03-0.15 wt.% of Si, less than or equal to 0.10 wt.% of Cr, less than or equal to 0.10 wt.% of Zn, 0.01-0.10 wt.% of Ti and balance of Al and inevitable impurities. In the aluminum alloy, the Mg not only guarantees the strength of the aluminum, but also meets the requirements on plasticity and corrosion resistance when the aluminum alloy is used for making automobile body plates. The Cu can further improve the strength of the prepared aluminum alloy and can enable the aluminum alloy to have better baking softening resistance and forming performance.

EP 0 681 034 A1 is directed to a method for manufacturing an aluminum alloy sheet for use in body panel material, and the aluminum alloy sheet manufactured by this method. The method of said document has the steps of obtaining an ingot by casting a melted aluminum alloy whose Mg content is 4 to 10 wt.%, and whose contents of Fe, Mn, Cr, Ti, and Zr are restricted to the value f satisfying the following equation I, and the rest of which is balanced up with Al, obtaining a rolled sheet by applying a cold rolling treatment to the ingot at a cold reduction R satisfying the following equation II, after the ingot is subjected to a hot rolling treatment, subjecting the rolled sheet to a final annealing treatment including the processes of raising the temperature to 450 to 550°C at a rate of 100°C/min or more, and being kept at the attained temperature for 300 second or less, and obtaining an aluminum alloy sheet by subjecting the rolled sheet to a cooling treatment at a cooling rate of 100°C/min or more, wherein f = [Fe] + 1.1[Mn] + 1.1[Cr] + 3[Ti] + 3 [Zr]. [Fe], [Mn], [Cr], [Ti], and [Zr] represent the contents of Fe, Mn, Cr, Ti, and Zr, respectively, in terms of percentages by weight.

JP 2005-139494 A is directed to an aluminum alloy sheet having a composition comprising 2.0-7.0% Mg, and, if required, comprising one or more kinds of metal selected from 0.05-1.0% Cu, 0.01-0.8% Mn, 0.01-0.3% Cr and 0.01-0.2% Zn, and the balance substantially Al, and in which over the whole range of the sheet thickness, the orientation density in the {100} face is < 1, the orientation density in the {111} face is > 1, and the average r value is ≥ 0.9. In the production method, after hot rolling accompanied by recrystallization, different peripheral speed rolling is performed at a draft of ≥ 30% in the nonrecrystallization temperature region of 170 to 350°C, and thereafter, a recrystallization heat treatment is performed. The different peripheral speed rolling is performed at a peripheral speed ratio of 1:1.2 or higher in particular.

The International Alloy Designations by The Aluminum Association disclose standard alloys AA5027, AA5019, AA5019A, AA5023, AA5182, AA5083 and AA5183.

JP 2010-053367 A is directed to an aluminum alloy sheet which has a composition comprising 4.3 to 5.5% Mg, 0.35 to 0.55% Mn, 0.04 to 0.30% Si, 0.12 to 0.40% Fe, and the balance Al with unavoidable impurities. The sheet has a sheet thickness of 0.20 to 0.25 mm, has an organic resin film formed on one side or both sides thereof and shows such mechanical properties that when tensile tests in directions of 0%, 45% and 90% with respect to a rolling direction of the aluminum alloy sheet have been conducted, a difference between the minimum value of yield stress and the minimum value of tensile strength is 30 to 65 MPa.

CN 104561696 A is directed to a 5083 aluminum alloy plate for a high-speed rail and a production method thereof. The 5083 aluminum alloy plate for the high-speed rail is prepared from the following raw materials in percentages by weight: 0.20-0.30% of Si, 0.20-0.30% of Fe, 0.03-0.07% of Cu, 0.45-0.60% of Mn, 5.0-5.3% of Mg, 0.10-0.20% of Cr, 0.015-0.03% of Ti, 0-0.10% of Zn, and the balance of Al. The production method comprises the steps of preparing the raw materials, smelting, casting, sawing off the head, milling the surface, soaking, hot rough rolling, hot finishing, cold rolling, bending and straightening, annealing and slicing up.

WO 03/074747 A1 relates to an aluminum alloy sheet or strip with a thickness of between 1 and 5 mm which is intended for the production of stamped and bent parts having a small bend radius. The composition (% by weight) of said alloy comprises: Si<0.4, Fe<0.4, Cu<0.4, Mn + Cr:0.3-0.7, Mg:4-5.5, Zn<1, other elements <0.05 each and <0.15 in total, and the remainder aluminum. Moreover, the sheet or strip according to this document presents the following properties: an elastic limit R_{0.2} in direction T>215 MPa, elongation A₈₀>15 % and a difference Rₘ - R_{0.2} >80 MPa. The sheets and strips are used, for example, for the production of parts for motor vehicles, such as reinforcements for openable panels or jacks.

### SUMMARY

The automotive body part according to the invention is defined in claim 1. The method of producing the automotive body part is defined in claim 3. The preferred embodiments are defined in the dependent claims.

Provided herein are novel automotive body parts comprising aluminum-containing 5XXX series alloys. The alloys exhibit high strength, high formability, and corrosion resistance. The aluminum alloys described herein comprise 0.10 - 0.15 wt. % Si, 0.20 - 0.35 wt. % Fe, 0.1 - 0.25 wt. % Cu, 0.20 - 0.50 wt. % Mn, 5.0 - 6.0 wt. % Mg, 0.05 - 0.20 wt. % Cr, 0.01 - 0.20 wt. % Zn, 0 - 0.05 wt. % Ti, and up to 0.15 wt. % total and up to 0.05 wt.% each of impurities, with the remainder as Al. The alloy includes α-AlFeMnSi particles. The alloy can be produced by casting (e.g., direct casting or continuous casting), homogenization, hot rolling, cold rolling, and annealing. The automotive body parts can comprise inner panels.

Further provided herein are methods of producing an automotive body part. The methods include the steps of casting an aluminum alloy as described herein to form an ingot; homogenizing the ingot to form a plurality of α-AlFeMnSi particles in the ingot; cooling the ingot to a temperature of 450 °C or less; hot rolling the ingot to produce a rolled product; optionally cold rolling the rolled product to an intermediate gauge; allowing the rolled product to self-anneal; and cold rolling the rolled product to a final gauge.

Other objects and advantages of the invention will be apparent from the following detailed description of non-limiting examples of the invention.

### BRIEF DESCRIPTION OF THE FIGURES

Figure 1 is a flowchart depicting processing routes for making the alloys described herein.

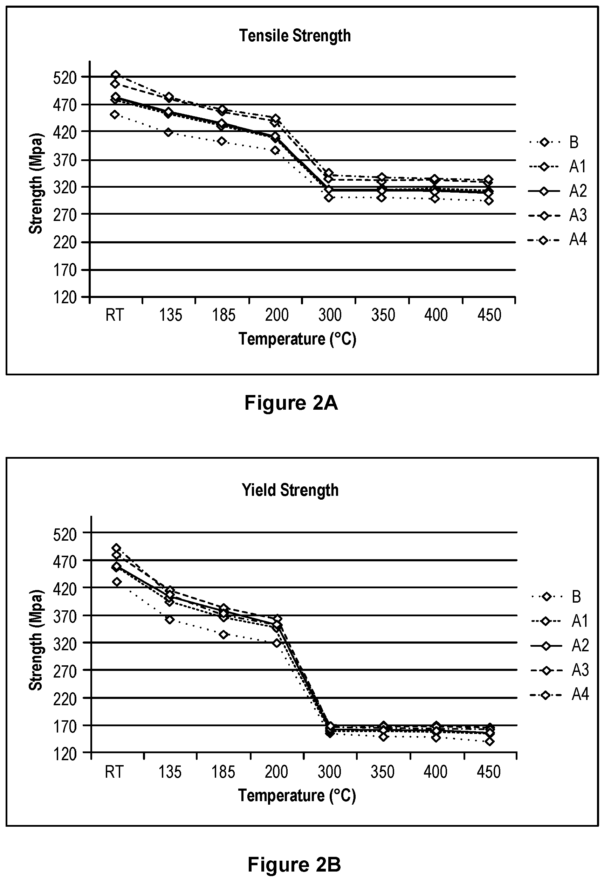

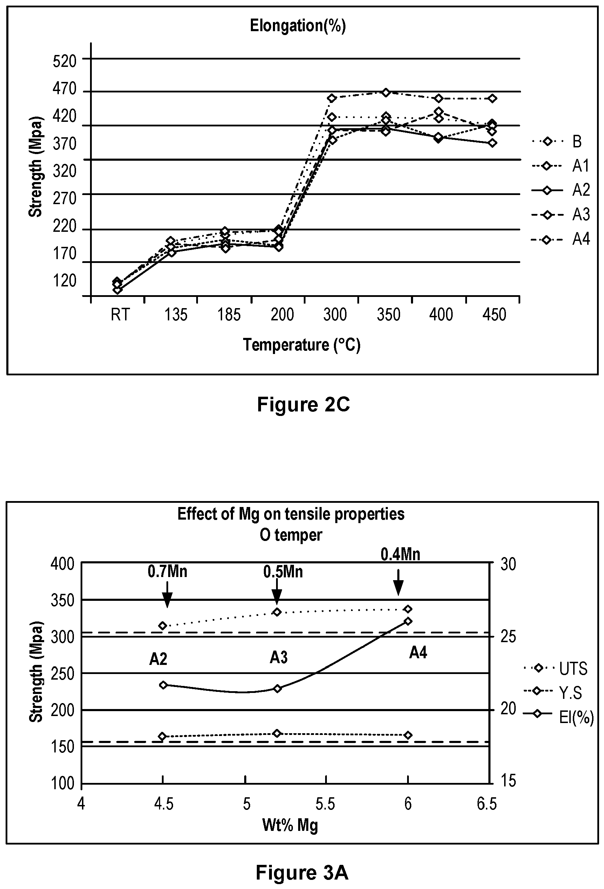

Figure 2A is a graph showing the tensile strength for the prototype alloy described herein, for alloys not according to the invention and for the comparison alloy. Figure 2B is a graph showing the yield strength for the prototype alloy described herein, for alloys not according to the invention and for the comparison alloy. Figure 2C is a graph showing the percent elongation for the prototype alloy described herein, for alloys not according to the invention and for the comparison alloy. In Figures 2A, 2B, and 2C, "B" represents comparison alloy K5182, "A3" represents the prototype alloy and alloys A1, A2 and A4 represent alloys not according to the invention.
Figure 3A is a graph showing the effect of Mg on tensile properties with Alloys A2 (4.5 wt. % Mg), A3 (5.2 wt. % Mg), and A4 (6.0 wt. % Mg) in their O-tempered conditions prior to testing. Figure 3B is a graph showing the effect of Mg on tensile properties with Alloys A2, A3, and A4 in their H38-tempered conditions, where the stabilization was performed at 135 °C, prior to testing. Figure 3C is a graph showing the effect of Mg on tensile properties with Alloys A2, A3, and A4 in their H38-tempered conditions, where the stabilization was performed at 185 °C, prior to testing.
Figure 4 is a picture of exemplary alloys assigned a ranking value based on the surface appearance.
Figure 5 is a graph showing the amount of weight loss that occurs after stabilizing the samples at 135 °C (left bar for each sample), 185 °C (middle bar for each sample), and 350 °C (right bar for each sample) for Alloys K5182 (represented as "B") and Alloys A1, A2, A3, and A4 and Alloy G.
Figure 6A is a picture of the Alloy G material after stabilization at a temperature range of from 100 - 130 °C. Figure 6B is a picture of Alloy A4 after stabilization at 135 °C.
Figure 7 is a group of pictures showing the effects of stabilization at 135 °C, stabilization at 185 °C, and full anneal at 350 °C on the microstructures for Alloys A1, A3, and A4.
Figure 8A is a graph of strength versus percentage cold work for Alloy A4 prepared at a stabilization temperature of 135 °C. Figure 8B is a graph of strength versus percentage cold work for Alloy A4 prepared at a stabilization temperature of 185 °C.
Figure 9 is a flowchart depicting processing routes for making the alloys described herein.
Figure 10A is a graph showing the acidic anodizing response of prototype alloy Example 1, comparative alloy AA5052, and comparative alloy AA5182. The graph shows the brightness (represented as "L"; left bar in each set), the white index (represented as "WI"; right bar in each set), and the yellow index (represented as "YI"; diamonds in graph).
Figure 10B is a graph showing the caustic anodizing response of prototype alloy Example 1, comparative alloy AA5052, and comparative alloy AA5182. The graph shows the brightness (represented as "L"; left bar in each set), the white index (represented as "WI"; right bar in each set), and the yellow index (represented as "YI"; diamonds in graph).
Figure 11 is a graph showing the tensile properties for prototype alloy Example 1, AA5052, and AA5182). The graph shows the yield strength (represented as "YS"; left bar in each set), the ultimate tensile strength (represented as "UTS"; right bar in each set), the uniform elongation (represented as "Uni. El. (%)"; diamonds in graph), and the total elongation (represented as "Total El. (%)"; circles in graph).

### DETAILED DESCRIPTION

Described herein are novel automotive body parts comprising 5XXX series aluminum alloys as defined in claim 1 which exhibit high strength and high formability. The alloys described herein are also insensitive to intergranular corrosion and are highly recyclable. In the soft annealed condition, these alloys exhibit high formability which allows for complex geometry applications. Surprisingly, the alloys described herein also exhibit high formability in other tempers as well. The high strength, high formability, and corrosion resistance properties are stable and are maintained throughout the life of any products prepared using the alloys. In other words, little or no ageing occurs during storage, processing, or service.

### Alloy Composition

The novel automotive body parts described herein comprise aluminum-containing 5XXX series alloys. The alloys exhibit high strength, high formability, and corrosion resistance. The properties of the alloy are achieved due to the elemental composition of the alloy.

The alloy has the following elemental composition as provided in Table 1.

**Table 1**

| **Element** | **Weight Percentage (wt. %)** |
|---|---|
| Si | 0.10-0.15 |
| Fe | 0.20-0.35 |
| Cu | 0.1-0.25 |
| Mn | 0.20-0.50 |
| Mg | 5.0-6.0 |
| Cr | 0.05-0.20 |
| Zn | 0.01-0.20 |
| Ti | 0-0.05 |
| Others | 0 - 0.05 (each) |
| | 0- 0.15 (total) |
| Al | Remainder |

The alloy described herein includes silicon (Si) in an amount of from 0.10 % to 0.15 based on the total weight of the alloy. For example, the alloy can include 0.10 %, 0.11 %, 0.12 %, 0.13 %, 0.14 %, or 0.15 % Si. All expressed in wt. %.

The alloy described herein also includes iron (Fe) in an amount of from 0.20 % to 0.35 % based on the total weight of the alloy. For example, the alloy can include 0.20 %, 0.21 %, 0.22 %, 0.23 %, 0.24 %, 0.25 %, 0.26 %, 0.27 %, 0.28 %, 0.29 %, 0.30 %, 0.31 %, 0.32 %, 0.33 %, 0.34 %, or 0.35 % Fe. All expressed in wt. %.

The alloy described includes copper (Cu) in an amount of from 0.1 % to 0.25 % based on the total weight of the alloy. For example, the alloy can include 0.10 %, 0.11 %, 0.12 %, 0.13 %, 0.14 %, 0.15 %, 0.16 %, 0.17 %, 0.18 %, 0.19 %, 0.20 %, 0.21 %, 0.22 %, 0.23 %, 0.24 %, or 0.25 % Cu. All expressed in wt. %.

The alloy described herein includes manganese (Mn) in an amount of from 0.20 to 0.50 % (e.g., from 0.40 % to 0.50 %) based on the total weight of the alloy. For example, the alloy can include 0.20 %, 0.21 %, 0.22 %, 0.23 %, 0.24 %, 0.25 %, 0.26 %, 0.27 %, 0.28 %, 0.29 %, 0.30 %, 0.31 %, 0.32 %, 0.33 %, 0.34 %, 0.35 %, 0.36 %, 0.37 %, 0.38 %, 0.39 %, 0.40 %, 0.41 %, 0.42 %, 0.43 %, 0.44 %, 0.45 %, 0.46 %, 0.47 %, 0.48 %, 0.49 %, or 0.50 % Mn. The Mn content results in the precipitation of α-AlFeMnSi particles during homogenization, which can result in additional dispersoid strengthening.

The alloy described herein includes magnesium (Mg) in an amount of from 5.0 to 6.0 %. In some examples, the alloy can include 5.0 %, 5.1 %, 5.2 %, 5.3 %, 5.4 %, 5.5 %, 5.6 %, 5.7 %, 5.8 %, 5.9 %, or 6.0 % Mg. All expressed in wt. %. The inclusion of Mg in the alloys described herein in an amount of from 5.0 to 6.0 % is referred to as a "high Mg content." Mg can be included in the alloys described herein to serve as a solid solution strengthening element for the alloy. As described further below, and as demonstrated in the Examples, the high Mg content results in the desired strength and formability, without compromising the corrosion resistance of the materials.

The alloy described herein includes chromium (Cr) in an amount of from 0.05 % to 0.20 % based on the total weight of the alloy. For example, the alloy can include 0.05 %, 0.06 %, 0.07 %, 0.08 %, 0.09 %, 0.10 %, 0.11 %, 0.12 %, 0.13 %, 0.14 %, 0.15 %, 0.16 %, 0.17 %, 0.18 %, 0.19 %, or 0.20 % Cr. All expressed in wt. %.

The alloy described herein includes zinc (Zn) in an amount of from 0.01 to 0.20 % based on the total weight of the alloy. For example, the alloy can include 0.01 %, 0.02 %, 0.03 %, 0.04 %, 0.05 %, 0.06 %, 0.07 %, 0.08 %, 0.09 %, 0.10 %, 0.11 %, 0.12 %, 0.13 %, 0.14 %, 0.15 %, 0.16 %, 0.17 %, 0.18 %, 0.19 %, or 0.20 % Zn. All expressed in wt. %.

In some examples, the alloy described herein includes titanium (Ti) in an amount of 0 % to 0.05 % based on the total weight of the alloy. For example, the alloy can include 0.01 %, 0.02 %, 0.03 %, 0.04 %, or 0.05 % Ti. In some cases, Ti is not present in the alloy (i.e., 0 %). All expressed in wt. %.

Optionally, the alloy compositions described herein can further include other minor elements, sometimes referred to as impurities, in amounts of 0.05% or below, 0.04% or below, 0.03% or below, 0.02% or below, or 0.01% or below each. These impurities may include, but are not limited to, V, Zr, Ni, Sn, Ga, Ca, or combinations thereof. Accordingly, V, Zr, Ni, Sn, Ga, or Ca may be present in alloys in amounts of 0.05% or below, 0.04% or below, 0.03% or below, 0.02% or below, or 0.01% or below. The sum of all impurities does not exceed 0.15% (e.g., 0.10%). All expressed in wt. %. The remaining percentage of the alloy is aluminum.

### Methods of Making

The alloys described herein are cast into ingots using a Direct Chill (DC) process. The casting process is performed according to standards commonly used in the aluminum industry as known to one of skill in the art. The casting process is a DC casting process to form a cast ingot.

The cast ingot is then subjected to further processing steps. The further processing steps are used to prepare sheets. Such processing steps include, but are not limited to, a homogenization step, a hot rolling step, an optional first cold rolling step to produce an intermediate gauge, an annealing step, and a second cold rolling step to a final gauge. The processing steps are described below in relation to a cast ingot.

The homogenization is carried out to precipitate α-AlFeMnSi particles. The α-AlFeMnSi particles can result in the formation of dispersoids during subsequent strengthening processes. In the homogenization step, an ingot prepared from the alloy compositions described herein is heated to attain a peak metal temperature of at least 470 °C (e.g., at least 475 °C, at least 480 °C, at least 485 °C, at least 490 °C, at least 495 °C, at least 500 °C, at least 505 °C, at least 510 °C, at least 515 °C, at least 520 °C, at least 525 °C, or at least 530 °C). In some examples, the ingot is heated to a temperature ranging from 500 °C to 535 °C. The heating rate to the peak metal temperature is sufficiently low to allow time for AlsMgs phase dissolution. For example, the heating rate to the peak metal temperature can be 50 °C/hour or less, 40 °C/hour or less, or 30 °C/hour or less. The ingot is then allowed to soak (i.e., held at the indicated temperature) for a period of time during the first stage. In some cases, the ingot is allowed to soak for up to 5 hours (e.g., from 30 minutes to 5 hours, inclusively). For example, the ingot can be soaked at the temperature of at least 500 °C for 30 minutes, 1 hour, 2 hours, 3 hours, 4 hours, or 5 hours.

Optionally, the homogenization step described herein can be a two-stage homogenization process. In these cases, the homogenization process can include the above-described heating and soaking steps, which can be referred to as the first stage, and can further include a second stage. In the second stage of the homogenization process, the ingot temperature is increased to a temperature higher than the temperature used for the first stage of the homogenization process. The ingot temperature can be increased, for example, to a temperature at least five degrees Celsius higher than the ingot temperature during the first stage of the homogenization process. For example, the ingot temperature can be increased to a temperature of at least 475 °C (e.g., at least 480 °C, at least 485 °C, at least 490 °C, at least 495 °C, at least 500 °C, at least 505 °C, at least 510 °C, at least 515 °C, at least 520 °C, at least 525 °C, at least 530 °C, or at least 535 °C). The heating rate to the second stage homogenization temperature can be 5 °C/hour or less, 3 °C/hour or less, or 2.5 °C/hour or less. The ingot is then allowed to soak for a period of time during the second stage. In some cases, the ingot is allowed to soak for up to 5 hours (e.g., from 15 minutes to 5 hours, inclusively). For example, the ingot can be soaked at the temperature of at least 475 °C for 30 minutes, 1 hour, 2 hours, 3 hours, 4 hours, or 5 hours. Following homogenization, the ingot can be allowed to cool to room temperature in the ambient air.

The homogenization step should be performed fully to eliminate low melting constituents and prevent edge cracking. Incomplete homogenization causes massive edge cracks which originate from segregation of Mg₅Al₈ precipitates. Therefore, in some cases, Mg₅Al₈ is minimized or eliminated prior to hot rolling, which can improve fabricability.

Following the homogenization step, a hot rolling step is performed. To avoid ingot cracking during the hot rolling step, the ingot temperature is reduced to a temperature lower than the eutectic melting temperature of the Mg₅Al₈ precipitates (i.e., 450 °C). Therefore, prior to the start of hot rolling, the homogenized ingot is allowed to cool to 450 °C or less. The ingots can then be hot rolled to a 12 mm thick gauge or less. For example, the ingots can be hot rolled to a 10 mm thick gauge or less, 9 mm thick gauge or less, 8 mm thick gauge or less, 7 mm thick gauge or less, 6 mm thick gauge or less, 5 mm thick gauge or less, 4 mm thick gauge or less, 3 mm thick gauge or less, 2 mm thick gauge or less, or 1 mm thick gauge or less. In some examples, the ingots can be hot rolled to a 2.8 mm thick gauge. The hot rolled gauge can then undergo an annealing process at a temperature of from about 300 °C to 450 °C.

The cold rolling step can then be performed to result in an intermediate gauge. The rolled gauge can then undergo an annealing process at a temperature of from about 300 °C to about 450 °C, with a soak time of approximately 1 hour and controlled cooling to room temperature at a rate of about 50 °C/hour. Alternatively, a batch annealing process or a continuous annealing process can be performed. Following the annealing process, the rolled gauge can be cold rolled to a final gauge thickness of from 0.2 mm to 7 mm. The cold rolling can be performed to result in a final gauge thickness that represents an overall gauge reduction by 20 %, 50 %, 75 %, or 85 %. In some cases, the resulting sheet can be stabilized by holding the sheet at a temperature of from 100 °C - 250 °C (e.g., 135 °C, 160 °C, 185 °C, or 200 °C) for a period of time from 30 minutes to 2 hours (e.g., 1 hour).

The resulting sheets have the combination of desired properties described herein, including high strength, insensitivity to intergranular corrosion, and high formability under a variety of temper conditions, including O-temper and H3X-temper conditions, where H3X tempers include H32, H34, H36, or H38. Under O-temper conditions, the alloys can exhibit an ultimate tensile strength of greater than 310 MPa, a yield strength of greater than 160 MPa, and a percent elongation of greater than 22 %. Under H3X-temper conditions, the alloys can exhibit an ultimate tensile strength of greater than 420 MPa, a yield strength of greater than 360 MPa, and a percent elongation of greater than 12 %.

The alloys and methods described herein are used in automotive applications. In some cases, the alloys can be used in O-temper, H2X, F, T4, T6, and in H3X temper for applications that require alloys with high formability. As mentioned above, the H3X tempers include H32, H34, H36, or H38. In some cases, the alloys are useful in applications where the processing and operating temperature is 150 °C or lower. The alloys and methods described herein are used to prepare automobile body parts, such as inner panels.

The following examples will serve to further illustrate the present invention without, at the same time, however, constituting any limitation thereof.

### Example 1

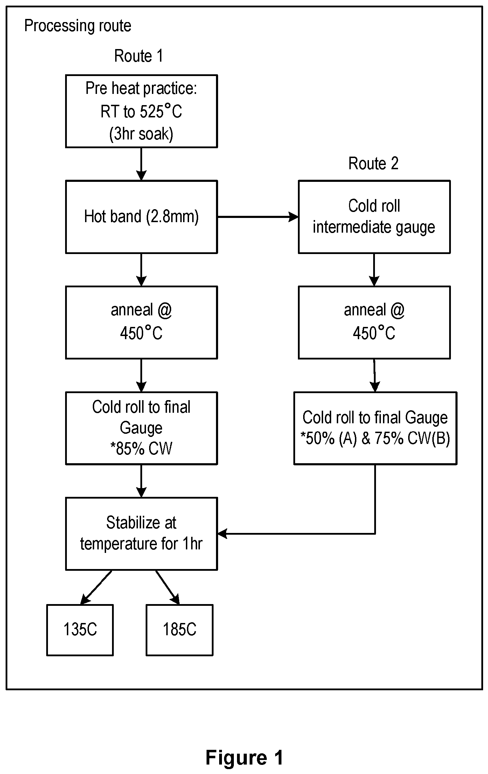

Alloys were prepared as described herein with or without the optional cold rolling to intermediate gauge step (see Figure 1). Specifically, the ingots were preheated from room temperature to 525 °C and allowed to soak for three hours. In the processing route without the optional cold rolling to intermediate gauge step, the ingots were then hot rolled to a 2.8 mm thick gauge, annealed at 450 °C for 1 hour followed by cooling to room temperature at a rate of 50 °C/hour, and then cold rolled to a final gauge thickness representing an overall gauge reduction by 85 %. The resulting sheets were allowed to stabilize at either 135 °C or at 185 °C for 1 hour. In the processing route with the optional cold rolling to intermediate gauge step, the ingots were hot rolled to a 2.8 mm thick gauge, cold rolled to an intermediate gauge, annealed at 300 to 450 °C for 1 hour, and then cold rolled to a final gauge thickness representing an overall gauge reduction by 50 % or 75 %. The resulting sheets were allowed to stabilize at either 135 °C or at 185 °C for 1 hour. The annealing process can be a controlled heating and cooling as described above, or alternatively can be a batch annealing or continuous annealing step.

### Example 2

Five alloys were prepared or obtained for tensile elongation testing (see Table 2). Alloy K5182, A1, A2, A3, and A4 were prepared according to the methods described herein. Specifically, the ingots having the alloy composition shown below in Table 2 were heated to 525 °C and soaked for 3 hours. The ingots were then hot rolled to a 2.8 mm thick gauge, cold rolled to an intermediate gauge, and annealed at 300 to 450 °C for 1 hour followed by cooling to room temperature at a rate of 50 °C/hour.

Cold rolling was then carried out to a final gauge thickness of from approximately 0.43 mm to 0.46 mm (overall gauge reduction by 50 % or by 75 %). The resulting sheets were allowed to stabilize at either 135 °C or at 185 °C for 1 hour. The elemental compositions of the tested alloys are shown in Table 2, with the balance being aluminum. The elemental compositions are provided in weight percentages. Alloy K5182 is an existing alloy commercially available from Novelis, Inc. (Atlanta, GA). Alloys A1, A2, A3, and A4 are prototype alloys prepared for the tensile, bendability, and corrosion resistance tests described below.

**Table 2**

| **Alloy** | **Si** | **Fe** | **Cu** | **Mn** | **Mg** | **Cr** | **Zn** | **Ti** |
|---|---|---|---|---|---|---|---|---|
| K5182 | 0.1 | 0.27 | 0.06 | 0.40 | 4.5 | 0.01 | 0.01 | 0.01 |
| A1^{∗} | 0.1 | 0.27 | 0.20 | 0.50 | 4.5 | 0.15 | 0.20 | 0.015 |
| A2^{∗} | 0.25 | 0.27 | 0.20 | 0.70 | 4.5 | 0.10 | 0.20 | 0.015 |
| A3 | 0.1 | 0.27 | 0.20 | 0.50 | 5.2 | 0.15 | 0.20 | 0.015 |
| A4^{∗} | 0.1 | 0.27 | 0.06 | 0.40 | 6.0 | 0.01 | 0.01 | 0.01 |

| | | | | | | | | |
|---|---|---|---|---|---|---|---|---|
| All expressed in wt. %. ^{∗}not according to the invention | | | | | | | | |

### Recyclability

The recyclability was estimated for each of the alloys from Table 2. The recycle content and prime content are listed below in Table 3. The recycle content is an estimate and was calculated using known models, which blend scrap chemistries from different sources.

**Table 3**

| | **K5182** | **A1** | **A2** | **A3** | **A4** |
|---|---|---|---|---|---|
| Recycle Content | 38% | 92% | 79% | 92% | 38% |
| Prime Content | 39% | 5% | 14% | 5% | 39% |

### Mechanical Properties

Tensile strength, yield strength, and elongation data were obtained for each alloy from Table 2. The testing was performed according to ASTM B557. The tensile strength, yield strength, and elongation data obtained from the four prototype alloys and from K5182 were compared, as shown in Figures 2A, 2B, and 2C, respectively. The data obtained from K5182 was included as a baseline comparison and is labeled in Figures 2A-2C as "B." All alloys were in their O-tempered conditions prior to tensile testing.

The four prototype alloys and K5182 from Table 2 were prepared under O-temper conditions, H38-temper conditions with stabilization at 135 °C, and H38-temper conditions with stabilization at 185 °C. The tensile strength, yield strength, and elongation data were obtained and are shown in Table 4. The testing was performed according to ASTM B557.

**Table 4**

| **Alloy** | **Temper** | **UTS(MPa)** | **YS(MPa)** | **El(%)** |
|---|---|---|---|---|
| Baseline | O-temper | 300 | 152 | 23 |
| A1 | | 314 | 162 | 23 |
| A2 | | 313 | 164 | 22 |
| A3 | | 332 | 168 | 22 |
| A4 | | 337 | 166 | 26 |
| Baseline | H38 (135 °C) | 419 | 362 | 8 |
| A1 | | 453 | 395 | 7.7 |
| A2 | | 455 | 404 | 7.0 |
| A3 | | 480 | 415 | 8.4 |
| A4 | | 482 | 407 | 8.5 |
| Baseline | H38 (185 °C) | 402 | 336 | 9.2 |
| A1 | | 431 | 368 | 8.8 |
| A2 | | 434 | 377 | 8.2 |
| A3 | | 456 | 383 | 8.2 |
| A4 | | 460 | 370 | 9.6 |

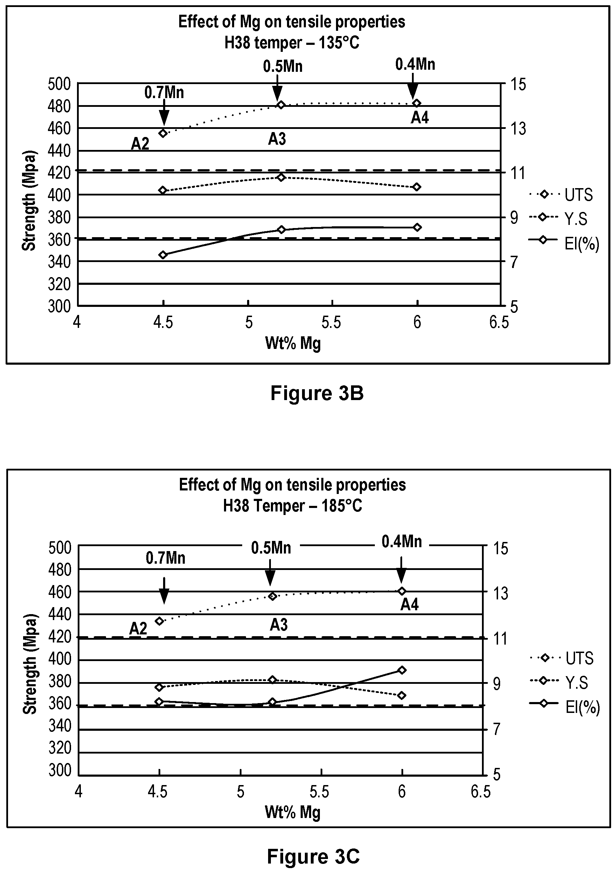

To determine the effect of Mg content in the alloys on the mechanical properties in the resulting sheets, the mechanical properties for Alloys A2, A3, and A4 were compared. Alloys A2, A3, and A4 contain 4.5, 5.2, and 6.0 wt. %, respectively. Figure 3A shows the effect of Mg on tensile properties with Alloys A2, A3, and A4 in their O-tempered conditions prior to testing. Figure 3B shows the effect of Mg on tensile properties with Alloys A2, A3, and A4 in their H38-tempered conditions, where the stabilization was performed at 135 °C, prior to testing. Figure 3C shows the effect of Mg on tensile properties with Alloys A2, A3, and A4 in their H38-tempered conditions, where the stabilization was performed at 185 °C, prior to testing. The tensile strengths of Alloys A3 and A4, which contain 5.2 wt. % and 6.0 wt. % Mg, respectively, were consistently higher than that of Alloy A2, which contains Mg in an amount of 4.5 wt. %.

### Bendability

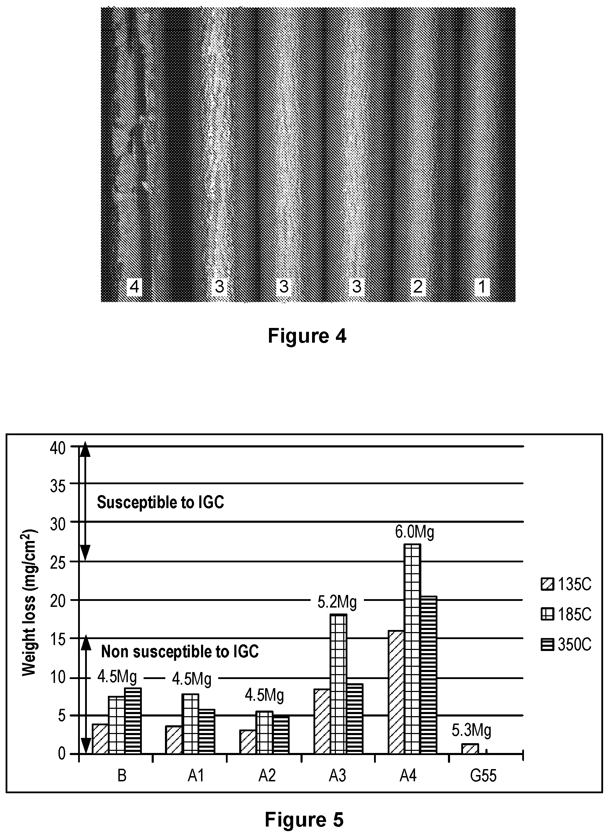

The bendability was determined for each of the prototype alloys, for the comparison material K5182, and for Alloy G, which is commercially available as Alloy GM55 from Sumitomo (Japan). The bendability was determined by measuring the hemming ability under a 90-180° bend and a radius of 0.5 mm. The samples were then ranked on a scale from 1 to 4 based on the surface appearance at the bend area. A ranking of "1" indicates a good surface appearance with no cracks. A ranking of "4" indicates that the samples contained short and/or long cracks at the bend area. Exemplary pictures of surface areas for alloys for each of the available ranking values are provided in Figure 4. The results are shown for each of the alloys in their O-tempered conditions; H38-tempered conditions, where the stabilization was performed at 135 °C; and H38-tempered conditions, where the stabilization was performed at 185 °C (see Table 5).

**Table 5**

| **Alloy** | **Temper** | **Rating** |
|---|---|---|
| K5182 | O-temper | 1 |
| A1 | | 1 |
| A2 | | 1 |
| A3 | | 1 |
| A4 | | 1 |
| K5182 | H38 (135C) | 3 |
| A1 | | 4 |
| A2 | | 4 |
| A3 | | 4 |
| A4 | | 4 |
| K5182 | H38 (185C) | 3 |
| A1 | | 4 |
| A2 | | 4 |
| A3 | | 4 |
| A4 | | 4 |
| Alloy G | H38 | 1 |

### Corrosion Resistance

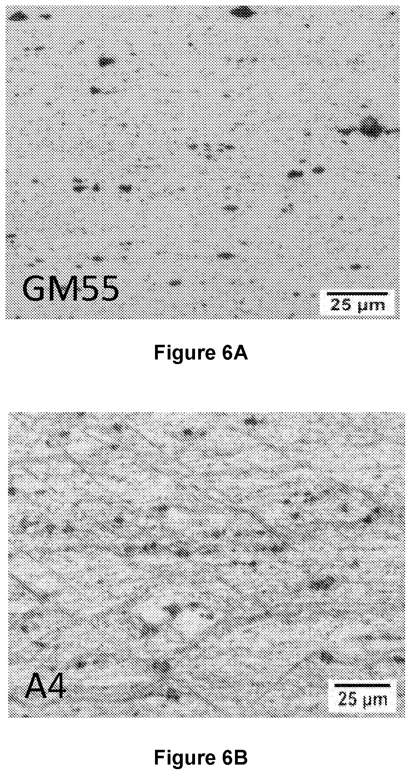

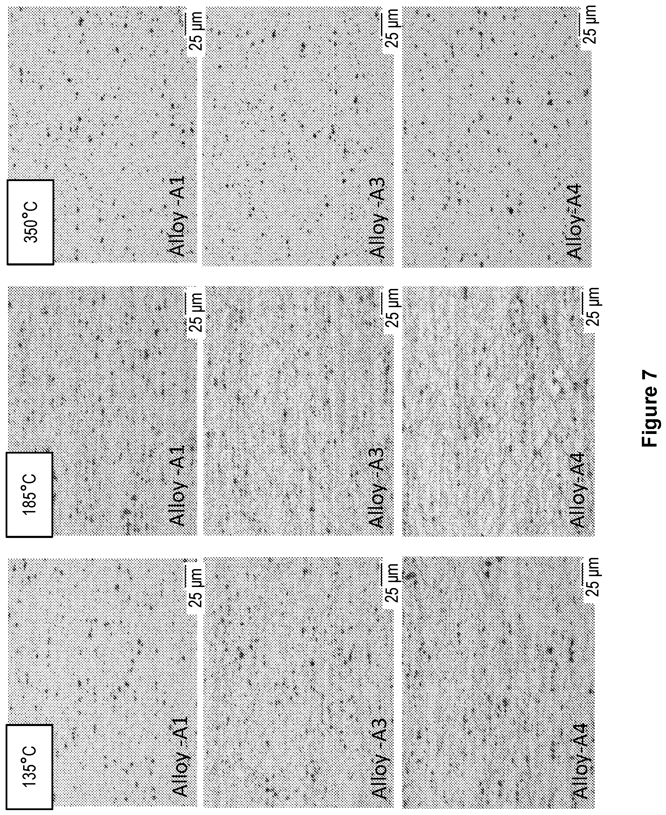

Corrosion resistance was determined for each of the prototype alloys A1 - A4, K5182, and Alloy G using the intergranular corrosion test NAMLT ("Nitric Acid Mass Loss Test;" ASTM-G67). The amount of weight loss that occurs after stabilizing the samples at 135 °C, 185 °C, and 350 °C (which represents a full anneal) are depicted in Figure 5. As shown in Figure 5, weight loss results after subjecting the samples to stabilization temperatures of 135 °C and 185 °C for 1 hour. Figure 6A shows the effects of subjecting the Alloy G material to stabilization at a temperature ranging from 100 - 130 °C. Figure 6B shows the effects of subjecting the Alloy A4 material to stabilization at 135 °C. The effects of stabilization at 135 °C, stabilization at 185 °C, and full anneal at 350 °C are also shown for Alloys A1, A3, and A4 in Figure 7.

### Effect of Cold Working Percentage on Mechanical Properties

To determine the effect of the cold working percentage on mechanical properties, the mechanical properties of Alloys A1, A4, and Alloy G were compared. Alloys A1 and A4 were prepared under cold work percentage of 50% or 75%, and the tensile strength, yield strength, percent elongation, and hemming were determined. The results are shown in Table 6.

**Table 6**

| **Alloy** | **Condition** | **Stabilization temp** | **Gauge(mm)** | **UTS(MPa)** | **YS(MPa)** | **EL%** | **Hemming test** |
|---|---|---|---|---|---|---|---|
| A1 | 75% CW | 135 °C | 0.435 | 432 | 373 | 8 | 4 |
| | 50% CW | | 0.448 | 402 | 332 | 8 | 1 |
| A4 | 75% CW | | 0.437 | 457 | 373 | 10 | 3 |
| | 50% CW | | 0.452 | 423 | 327 | 11 | 1 |
| | | | | | | | |
| A1 | 75% CW | 185 °C | 0.453 | 418 | 354 | 7 | 3 |
| | 50% CW | | 0.455 | 399 | 323 | 9 | 1 |
| A4 | 75% CW | | 0.434 | 444 | 352 | 9 | 3 |
| | 50% CW | | 0.456 | 415 | 315 | 13 | 1 |
| Alloy G | H3X | | 0.397 | 394 | 313 | 10 | 1 |

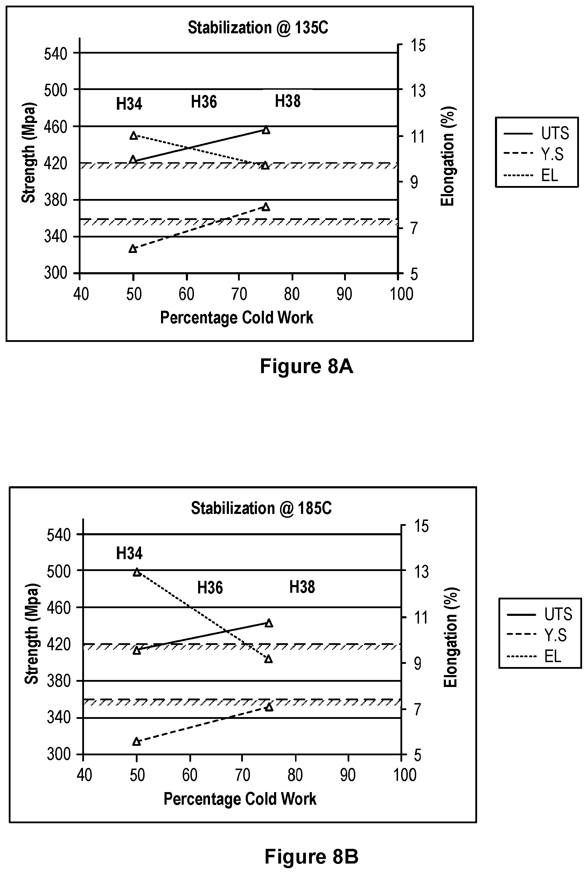

For Alloy A4, the strength versus the percentage cold work (CW) was plotted for the materials prepared at a stabilization temperature of 135 °C (Figure 8A) and 185 °C (Figure 8B). The process modification with 50 % CW significantly affected the mechanical properties of Alloy A4, which is a high Mg content alloy. The mechanical properties are higher than Alloy G, and the bendability was also good as demonstrated by the hemming testing.

### Example 3

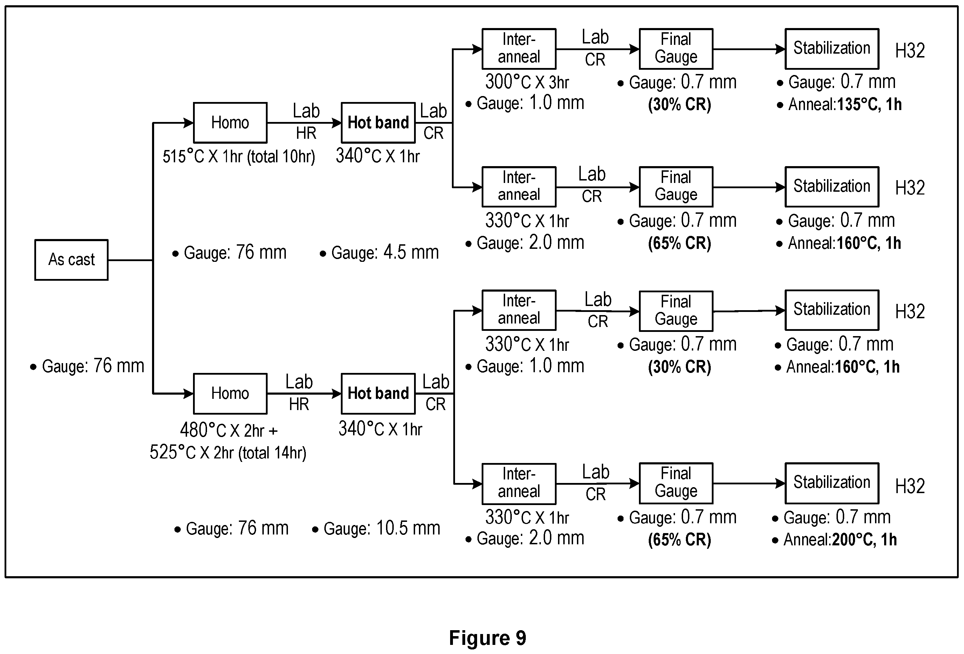

Alloys as described herein were prepared according to one of the processes shown in Figure 9. In a first process, the cast ingots were preheated from room temperature to 515 °C and allowed to soak for 1 hour. The total time lapsed for the preheating and soaking averaged 10 hours. The ingots were then hot rolled at 340 °C for 1 hour to a 4.5 mm thick gauge, annealed at 300 °C for 3 hours to result in a 1.0 mm thick gauge, and then cold rolled to a final gauge thickness of 0.7 mm, representing a 30% gauge reduction from the annealed gauge. The resulting sheets were allowed to stabilize at 135 °C for 1 hour. In a second process, the cast ingots were preheated, soaked, and hot rolled as described above for the first process. The annealing step was performed at 330 °C for 1 hour to result in a 2.0 mm thick gauge, and then cold rolled to a final gauge thickness of 0.7 mm, representing a 65% gauge reduction from the annealed gauge. The resulting sheets were allowed to stabilize at 160 °C for 1 hour.

In a third process, the cast ingots were preheated from room temperature to 480 °C and allowed to soak for 2 hours. The ingots were then heated to a second temperature of 525 °C and allowed to soak for 2 additional hours. The total time lapsed for the preheating, soaking, heating, and additional soaking steps averaged 14 hours. The ingots were then hot rolled at 340 °C for 1 hour to a 10.5 mm thick gauge, annealed at 330 °C for 1 hour to result in a 1.0 mm thick gauge, and then cold rolled to a final gauge thickness of 0.7 mm, representing a 30% gauge reduction from the annealed gauge. The resulting sheets were allowed to stabilize at 160 °C for 1 hour. In a fourth process, the cast ingots were preheated, soaked, heated, soaked, and hot rolled as described above for the third process. The annealing step was performed at 330 °C for 1 hour to result in a 2.0 mm thick gauge, and then cold rolled to a final gauge thickness of 0.7 mm, representing a 65% gauge reduction from the annealed gauge. The resulting sheets were allowed to stabilize at 200 °C for 1 hour. The processes described above resulted in alloys in their H32 tempered conditions.

### Example 4

Prototype alloy Example 1 was prepared for anodizing quality testing and tensile property testing. The elemental composition of Example 1 is shown in Table 7, with the balance being aluminum, and values are provided in weight percentages. Example 1 was prepared according to the methods described herein. Alloys AA5052 and AA5182 were obtained and were also tested for anodizing quality and tensile properties. Alloy AA5182 is an existing alloy commercially available from Novelis, Inc. (Atlanta, GA). Alloy AA5052 is an alloy that was prepared in the laboratory.

**Table 7**

| **Alloy** | **Si** | **Fe** | **Cu** | **Mn** | **Mg** | **Cr** | **Zn** | **Ti** |
|---|---|---|---|---|---|---|---|---|
| Example 1^{∗} | 0.05-0.15 | 0.09-0.15 | ∼ 0.05 | ∼ 0.10 | 4.0-5.5 | ∼ 0.20 | ~ 0.005 | ~ 0.05 |

| | | | | | | | | |
|---|---|---|---|---|---|---|---|---|
| ^{∗}not according to the invention | | | | | | | | |

### Anodizing Quality

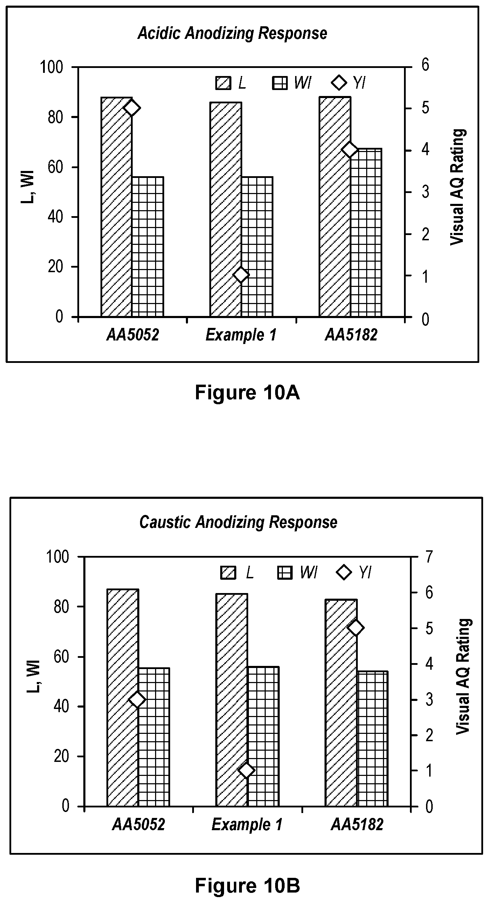

The anodizing responses under acidic and caustic conditions were obtained for prototype alloy Example 1, for comparative alloy AA5182, and for comparative alloy AA5052. Specifically, the brightness (represented as "L"), the white index (represented as "WI"), and the yellow index (represented as "YI") for the alloys were determined. As illustrated in Figures 10A-10B, the prototype alloy showed improved anodizing qualities, such as lower YI values, which may be due to the reduced size and number density of intermetallic particles in the alloy sample.

### Mechanical Properties

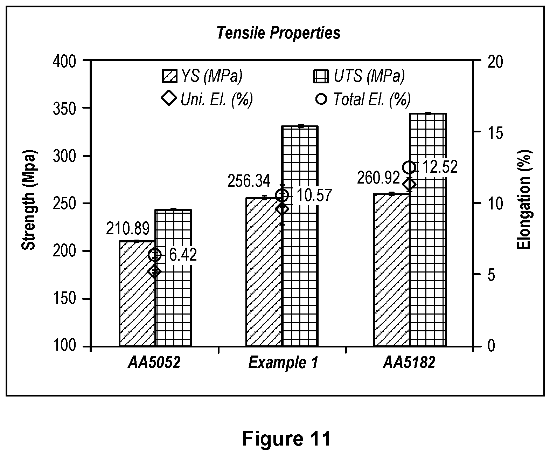

Yield strength, ultimate tensile strength, uniform elongation, and total elongation data were obtained for prototype alloy Example 1, for comparative alloy AA5182, and for comparative alloy AA5052. The testing was performed according to ASTM B557. The tensile strength, yield strength, and elongation data obtained from the alloys were compared, as shown in Figure 11. The strength and formability values of prototype alloy Example 1 were higher than those of AA5052 and comparable to those of AA5182.

Various embodiments of the invention have been described in fulfillment of the various objectives of the invention. It should be recognized that these embodiments are merely illustrative of the principles of the present invention. Numerous modifications and adaptations thereof will be readily apparent to those of ordinary skill in the art without departing from the scope of the invention as defined in the following claims.

## Claims

1. An automotive body part comprising an aluminum alloy comprising 0.10 - 0.15 wt. % Si, 0.20 - 0.35 wt. % Fe, 0.1 - 0.25 wt. % Cu, 0.20 - 0.50 wt. % Mn, 5.0 - 6.0 wt. % Mg, 0.05 - 0.20 wt. % Cr, 0.01 - 0.20 wt. % Zn, 0 - 0.05 wt. % Ti, and up to 0.15 wt. % total and up to 0.05 wt.% each of impurities, with the remainder as Al, wherein the alloy includes α-AlFeMnSi particles and wherein the alloy is produced by direct chill casting and the alloy is produced by homogenization, hot rolling, cold rolling, and annealing.

2. The automotive body part of claim 1, wherein the automotive body part comprises an inner panel.

3. A method of producing the automotive body part according to claim 1, comprising:
direct chill casting an aluminum alloy comprising 0.10 - 0.15 wt. % Si, 0.20-0.35 wt. % Fe, 0.1 - 0.25 wt. % Cu, 0.20 - 0.50 wt. % Mn, 5.0 - 6.0 wt. % Mg, 0.05 - 0.20 wt. % Cr, 0.01 - 0.20 wt. % Zn, 0 - 0.05 wt. % Ti, and up to 0.15 wt. % total and up to 0.05 wt.% each of impurities, with the remainder as Al, to form an ingot homogenizing the ingot to form a plurality of α-AlFeMnSi particles in the ingot;
cooling the ingot to a temperature of 450 °C or less;
hot rolling the ingot to produce a rolled product;
allowing the rolled product to self-anneal; and
cold rolling the rolled product to a final gauge.

4. The method of claim 3, further comprising cold rolling the rolled product to an intermediate gauge after the hot rolling step.

## Patentansprüche

1. Kraftfahrzeugkarosserieteil, umfassend eine Aluminiumlegierung, die 0,10 - 0,15 Gew.-% Si, 0,20 - 0,35 Gew.-% Fe, 0,1 - 0,25 Gew.-% Cu, 0,20 - 0,50 Gew.-% Mn, 5,0 - 6,0 Gew.-% Mg, 0,05 - 0,20 Gew.-% Cr, 0,01 - 0,20 Gew.-% Zn, 0 - 0,05 Gew.-% Ti und bis zu 0,15 Gew.-% Verunreinigungen insgesamt und bis 0,05 Gew.-% je Verunreinigung umfasst, wobei der Rest Al ist, wobei die Legierung a-AlFeMnSi-Teilchen enthält und wobei die Legierung durch direktes Kokillengießen hergestellt wird und die Legierung durch Homogenisieren, Warmwalzen, Kaltwalzen und Glühen hergestellt wird.

2. Kraftfahrzeugkarosserieteil nach Anspruch 1, wobei das Kraftfahrzeugkarosserieteil ein Innenblech umfasst.

3. Verfahren zur Herstellung des Kraftfahrzeugkarosserieteils nach Anspruch 1, umfassend:
direktes Kokillengießen einer Aluminiumlegierung, die 0,10 - 0,15 Gew.-% Si, 0,20 - 0,35 Gew.-% Fe, 0,1 - 0,25 Gew.-% Cu, 0,20 - 0,50 Gew.-% Mn, 5,0 - 6.0 Gew.-% Mg, 0,05 - 0,20 Gew.-% Cr, 0,01 - 0,20 Gew.-% Zn, 0 - 0,05 Gew.-% Ti und bis zu 0,15 Gew.-% Verunreinigungen insgesamt und bis 0,05 Gew.-% je Verunreinigung umfasst, wobei der Rest Al ist, um einen Block zu bilden;
Homogenisieren des Blocks, um eine Vielzahl von α-AlFeMnSi-Teilchen in dem Block zu bilden;
Abkühlen des Blocks auf eine Temperatur von 450 °C oder weniger;
Warmwalzen des Blocks zur Herstellung eines gewalzten Produkts;
Zulassen des Selbsthärtens des gewalzten Produkts; und
Kaltwalzen des gewalzten Produkts auf eine Enddicke.

4. Verfahren nach Anspruch 3, weiterhin umfassend das Kaltwalzen des Walzprodukts auf eine Zwischendicke nach dem Warmwalzschritt.

## Revendications

1. Une pièce de carrosserie automobile comprenant un alliage d'aluminium comprenant 0,10 - 0,15 % en poids de Si, 0,20 - 0,35 % en poids de Fe, 0,1 - 0,25 % en poids de Cu, 0,20 - 0,50 % en poids de Mn, 5,0 - 6,0 % en poids de Mg, 0,05 - 0,20 % en poids de Cr, 0,01 - 0,20 % en poids de Zn, 0 - 0,05 % en poids de Ti, et jusqu'à 0,15 % en poids au total et jusqu'à 0,05 % en poids pour chacune des impuretés, le reste étant de l'Al, dans lequel l'alliage comprend des particules α-AlFeMnSi et dans lequel l'alliage est produit par coulée directe à froid et l'alliage est produit par homogénéisation, laminage à chaud, laminage à froid et recuit.

2. La pièce de carrosserie automobile selon la revendication 1, dans laquelle la pièce de carrosserie automobile comprend un panneau intérieur.

3. Une méthode de production de la pièce de carrosserie automobile selon la revendication 1, comprenant :
coulée directe à froid d'un alliage d'aluminium comprenant 0,10 - 0,15 % en poids de Si, 0,20 - 0,35 % en poids de Fe, 0,1 - 0,25 % en poids de Cu, 0,20 - 0,50 % en poids de Mn, 5,0 - 6,0 % en poids de Mg, 0,05 - 0,20 % en poids de Cr, 0,01 - 0,20 % en poids de Zn, 0 - 0,05 % en poids de Ti, et jusqu'à 0,15 % en poids au total et jusqu'à 0,05 % en poids pour chacune des impuretés, le reste étant de l'Al, pour former un lingot ;
homogénéiser le lingot pour former une pluralité de particules α-AlFeMnSi dans le lingot ;
refroidir le lingot à une température inférieure ou égale à 450 °C ;
laminage à chaud du lingot pour produire un produit laminé ;
laisser le produit laminé s'auto-réchauffer ; et
laminage à froid du produit laminé jusqu'à l'obtention d'un calibre final.

4. Méthode selon la revendication 3, comprenant en outre le laminage à froid du produit laminé à un calibre intermédiaire après l'étape de laminage à chaud.
